# EUROPEAN PATENT APPLICATION

(11) **EP 1 513 022 A1**
(43) Date of publication of application: **09.03.2005**
(21) Application number: 04077429.1
(22) Date of filing: 31.08.2004
(51) Int. Cl.: G03F 7/20

(54) **Lithographic apparatus and device manufacturing method**

(30) Priority: 04.09.2003 EP 03077785
(71) Applicant: ASML Netherlands B.V., 5504 DR Veldhoven (NL)
(72) Inventor: Franken, Dominicus J. P. A., 5508 JA Veldhoven (NL)
(74) Representative: Winckels, Johannes Hubertus F.

(57) **Abstract**

A lithographic apparatus comprising a projection optics assembly PL for projecting a patterned beam onto a target portion of the substrate , the assembly comprising a plurality of movable optical elements M1-M6 and a plurality of sensor units 25 for sensing the position and/or orientation of a respective optical element M1, the movable optical elements M1-M6 being arranged in a spaced relationship on a support frame 20, 200, wherein the support frame 20 is at least partly formed by an assembly of at least two interconnected segments 21, 22, 23, each of said segments movably mounting at least one of the optical elements M1-M6 and fixedly mounting at least one of the sensor units 25, wherein the support frame 20 serves as a reference and mounting frame within which said optical elements are mounted in said spaced relationship. In an alternative embodiment, the optical elements M1-M6 are movably mounted and the sensor units 25 are fixedly mounted on a single support frame 200.

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

A projection optics assembly including a support frame is known. Conventionally the projection optics assembly comprises a reference frame and a plurality of sensor frames which are mounted in the reference frame. The sensor frame is a frame adapted to support amongst other components, an optical element, typically a moveable mirror, one or more sensor unit(s) for sensing the position of the optical element and one or more actuator(s), which is responsive to the sensor unit, for moving the optical element to a desired position. A separate sensor frame is provided for each mirror. Such a sub-assembly is conventionally referred to as a "mirror module". Conventionally, the approach to designing a support frame is to provide a plurality of mirror modules. The exact number will depend on the particular projection optics assembly. Typically, however, the projection optics assembly includes 6 mirrors. Each mirror module includes a sensor frame, that contains all the necessary components to have a fully functional adjustable mirror. Each of these mirror modules are then mounted into a common reference frame, typically made of a low expansion glass material, such as Zerodur. Typically one of the mirrors in the projection optics assembly is stationary. In conventional systems, this stationary mirror is also mounted on the common reference frame.

Such conventional arrangements have problems. Firstly, in order to mount the components on the sensor frame a large number of optical spacers are required. In particular, a large number of spacers are necessary to mount a sensing element which senses the position of the mirror. The use of spacers in the arrangement is expensive in particular, in terms of the man hours required to mount the spacers in the sensor frame.

Secondly, it has been found that attaining accurate positioning after mounting the mirror modules in the reference frame can only be achieved using yet further spacers, which adds further to the manufacturing costs and time scales of the support frame.

Thirdly, the mirror modules are mounted into the reference frame using a so-called "statically determined interface". Such an interface comprises elements whose functionality may be compared with a flexible rod, since the interface element is designed to be stiff in one direction, and as compliant as possible in the other five directions. The interface elements are complex constructions, each comprising a number of parts. Typically an interface element connects two Zerodur parts of the support frame construction. For example, one side the interface element connects with the reference frame, and at the other side, the interface element connects with the sensor frame. The interface elements are attached to respective Zerodur frame parts. The attachments are metal inserts. These inserts are glued into the Zerodur. In an attempt to minimise thermal problems caused by the inserts, they have a particular design. It has been found that, in spite of the design of the inserts, the fact that metal inserts need to be glued into the two Zerodur frame parts to be connected increases the thermal stability problem.

Furthermore, the interface element has to allow for manufacturing tolerances of holes formed in the interface elements in order to connect them to the frame. This results in a misalignment, both in position and angle of the two inserts glued into the two parts to be connected. Conventional interface elements must, therefore, also include an element to allow and compensate for this. Also, since the insert is of a metal material, its thermal expansion in a longitudinal direction is non-zero. This longitudinal direction is the stiff direction, the direction determining the position of the module relative to the reference structure. This position, should ideally remain as constant as possible with changing temperature, and must also be compensated for internally. Also, a conventional interface, also requires an element to lock the interface element into place once the mirror module is positioned. From the above discussion, it will be understood that the conventionally required interface is highly complex in terms of design and implementation.

A "statically determined interface" is one in which the interface is made such that only six degrees of freedom (DOFs) of a module are constrained (no more and no less). This means that the module is mounted in six degrees of freedom to its environment. In an ideal case, this means that if the environment distorts, for example, due to thermal effects, the suspended module will only displace and/or rotate as a whole, but it will not distort. The less statically determined an interface becomes, due to parasitical stiffnesses, the more distortion of the environment, in this case the reference structure, will cause internal distortion of the module itself. This is unwanted.

One way of creating a conventional statically determined interface is to design six identical interface elements which approximate the functionality of a flexible rod as near as possible. These six interface elements must be positioned and oriented in such a way that they are capable of constraining six degrees of freedom of the module, but not less. As discussed previously, however, this is a highly complex design.

For some time, it has been the conventional thinking, in view of the manufacturability, reliability and testability demands, required in a projection optics assembly, to provide a modular design. Inextricably linked with a conventional modular design is the interfacing of these modules. As discussed the interfacing of parts of a construction with high dynamic demands, such as those required in a projection optics assembly, is with precision mechanics. Thus, it is conventional to provide projection optics assemblies having a modular design and using complex interfaces to interface modules. Ideally, each module is a fully functional, fully tested unit. Therefore, mounting a module onto its appropriate interface must not distort or influence the fully tested unit in any way, both in the short term, during the mounting itself or in the long terms. As discussed "statically determined interfacing" is one approach. It has been found that one drawback of conventional "statically determined interfacing" is dynamic behaviour. Demands associated with the dynamic behaviour of a construction are associated with, and derived from its required performance specifications in terms of, for example, positional accuracy, which is derived from specifications regarding optical performance, related to image position and quality.

With respect to conventional arrangements, it has been found that it is no longer possible to design a sensor frame with statically determined interfaces that meet the dynamic demands of the projection optics assembly, within the volume available in the support frame, whilst leaving room for assembly, access and cabling, amongst other things, and whilst minimizing internal distortion.

Broadly speaking, one object of the present invention is to provide a module interface that takes into account aspects, such as distortion, both during and after mounting, meeting dynamic requirements, whilst providing thermal decoupling. Other considerations include electrical insulation of a module from its environment.

Further, in modem projection optics assemblies, a first moveable mirror is to be positioned with respect to a second mirror with sub-nanometre accuracy. It will be understood that in the conventional system described above, in order to do this, five distances must be accurately known: the distance between the first sensor unit and the first sensor frame, the first sensor frame and the reference frame associated with the first mirror module, the reference frame associated with the first mirror module and the reference frame associated with the second mirror module, the reference frame associated with the second mirror module and the second sensor frame, and the second sensor frame and the second sensor unit. Further problems associated with this arrangement are manufacturing tolerances and position accuracy since dynamic behaviour is associated with interface constructions. It will be understood that in order to go from one sensor on one sensor frame to another sensor on another sensor frame, eight mounting positions and four interface constructions must be passed through. Further, as mentioned, each construction part has its own internal inaccuracies. Also, each interface position has its own inaccuracies. So, therefore, the more construction parts, and the more interface positions there are, the smaller the inaccuracy value that is acceptable from each individual error contribution, in order to attain one constant acceptable value associated with the position of one sensor on one sensor frame with respect to another on another sensor frame. This latter value is the total value from all contributors. This value is a functional requirement, as it is derived from functional specifications. The more parts, the more contributors, the smaller the values from each individual contributor may be in order to attain a constant sum, to meet the functional requirements.

It has been found that conventional projection optics assemblies, even those constructed of glasses with low expansion coefficient, such as Zerodur, and constructed in such a manner to maximize their rigidity, the errors associated with each of the five distances accumulate to make it impossible to meet the initial sensor position accuracy of the projection optics assembly. This leads to a limited imaging quality.

It is an object of the present invention to overcome the problems identified with respect to conventional projection optics assemblies. In particular, it is an object of the present invention to improve the positioning accuracy of an optical element and the stability and dynamic performance of a projection optics assembly. A further object of the present invention is improve the manufacturability of the projection optics assembly.

According to an aspect of the invention, there is provided a lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection optics assembly for projecting the patterned beam onto a target portion of the substrate, said assembly comprising a plurality of movable optical elements and a plurality of sensor units for sensing the position and/or orientation of a respective optical element, said movable optical elements being arranged in a spaced relationship on a support frame, characterized in that said support frame comprises an assembly of at least two interconnected segments, each of said segments movably mounting at least one of said optical elements and fixedly mounting at least one of said sensor units, wherein said at least two interconnected segments serve as a reference and mounting frame within which said optical elements are mounted in said spaced relationship.

By providing an assembly comprising at least two interconnected segments, each of which movably mount at least one of the optical elements and fixedly mount one or more respective sensor unit(s), the conventional, separate, reference frame and the elements comprised in the statically determined interfaces can be dispensed with. In particular, the separate sensor and reference frame structures are replaced by one structure combining both functions. Thus, the manufacturability of the projection optics assembly is simplified. In particular, the design and interface complexity is reduced. Also, individual tolerancing requirements are reduced. Further, since the support and reference functions are provided by one support frame, the dynamic performance of the projection optics assembly is improved. The interfacing complexity is reduced as a number of interfaces and interfacing elements are no longer necessary. Further, due to the fact that the number of different parts is decreased, and since a number of interfaces are dispensed with, individual tolerancing can be relaxed.

Further, by dispensing with the separate conventional reference frame, the number of spacers required to manufacture the projection optics assembly is reduced. Also, the decreased number of construction parts and the associated reduction in the number of interfaces, reduces the number of spacers required. Further, the space previously required for the two separate frames is freed up for other purposes such as cabling, access and improved stiffness of the supporting frame structure. By constructing the support frame of a plurality of segments, it allows the support frame to be built up in a modular manner without reference or incorporation into a further structure. This increases the accessibility to components once assembled in the projection optics assembly.

Further, manufacturability is improved. For example, with regard to assembly, one segment, containing a (number of) mirror(s) can be accessed from both sides. Mirror(s), sensor, actuator, cabling and possible any other sub-module can be put into, and mounted onto the frame block of the segment, quite separate from and parallel to any other assembly activity, particularly the assembly of the other segments of the projection optics assembly.

In a preferred embodiment, the plurality of segments are adapted to interconnect with one another in a stacked arrangement. By stacking segments on top of one another, manufacture of the projection optics assembly is simplified. Once all segments are fully assembled and tested, they need to simply be stacked on top of each other to arrive at a fully functional projection optics assembly. In particular, final assembly is greatly facilitated according to the present invention, providing a decrease in production lead time.

In a preferred embodiment, the support frame comprises three segments, wherein at least two of the plurality of optical elements are mounted in at least each of two of the segments. By providing three segments, in two of which two optical elements are disposed, optical element accessibility and cable routing is optimised whilst optimising the mechanical properties of the support frame. Further accessibility of the sensors and actuators and any other module is improved.

In a preferred embodiment, the support frame comprises a plurality of inserts, wherein the inserts are adapted to be disposed between segments to form, in use, an interface zone, so that in an assembled state the inserts come into contact with one another, wherein at least a part of a surface defined by the contacting inserts forms a reference surface. By providing inserts between adjacent segments, and arranging the reference surface to lie within an interface zone formed by the contacting inserts, not only is alignment achieved, but any stresses exerted on the support frame in the interface zone are transferred to the inserts rather than through the support frame.

According to a further aspect of the present invention, there is provided a lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection optics assembly for projecting the patterned beam onto a target portion of the substrate comprising a plurality of movable optical elements and a plurality of sensor units for sensing the position and/or orientation of a respective optical element, said movable optical elements being arranged in a spaced relationship on a support frame,
characterized in that said optical elements are movably mounted and said sensor units are fixedly mounted on a single support frame, wherein said support frame comprises one segment which serves as a reference and mounting frame within which said optical elements are mounted in said spaced relationship. By providing the optical elements movably mounted and the sensor unit fixedly mounted on a single support frame, it is possible to dispense with a separate reference frame. The separate reference and sensor frame structures are replaced with a single structure combining both functions. By mounting the optical elements and sensor units in a single structure, the manufacture of the assembly is simplified, the long term stability and dynamic performance are improved.

In a preferred embodiment, the sensor unit or sensor units is or are mounted directly in the segment or segments at a predetermined location. By disposing the sensor unit or units directly in the support frame at a predetermined location, the number of distances which are to be known between two optical elements is reduced to one, that is the distance between a first sensor unit and a second sensor unit. Thus, the associated error measurement is reduced giving an improvement in the positioning accuracy of the optical elements with respect to one another.

In a preferred embodiment, the sensor unit senses the position and/or orientation of the respective optical element with respect to a reference surface located on or in the segment or segments, and the segment or segments is/are provided with an interface surface formed in the segment or segments for receiving the sensor unit, wherein the interface surface is disposed at the predetermined location, which is predetermined with respect to the reference surface. By providing an interface surface at the predetermined location, with respect to a reference surface, the accuracy with which the position and/or orientation of the mirror can be determined is improved.

In a preferred embodiment, the segment or segments fixedly supports an actuator coupled to the respective one of said plurality of optical elements, the actuator being responsive to a sensor unit, for moving the optical element to a predetermined location. By fixedly supporting an actuator coupled to a respective optical element in the segment or segments, all those components in the projection optics assembly which provide accurate alignment of one optical element with respect to a second optical element are mounted in the segment or segments. Thus, further simplifying the manufacture of the assembly.

In a further embodiment, when assembled, the segments interface with each other in a substantially horizontal plane. In this way, the segments are readily assembled and should any maintenance be necessary, they may be readily disassembled, so that the segment requiring maintenance can be removed without requiring the entire projection optics assembly to be disassembled. Thus, improving the ease of maintenance.

According to a further aspect of the invention, there is provided a method of assembling a projection optics assembly for a lithographic apparatus comprising the steps of:
- providing a plurality of interconnectable segments;
- on each segment movably mounting a plurality of optical elements disposed in a spaced relationship with respect to one another, and fixedly mounting at least one sensing element so as to sense the position and/or orientation of one of said plurality of said movably mounted optical elements; and
- interconnecting said segments so as to at least partially form a single support frame which serves as a reference and mounting frame within which said optical segmentable elements are mounted in said spaced relationship.

According to a further aspect of the present invention, there is provided a method of assembling a projection optics assembly for a lithographic apparatus comprising the steps of:
- providing a single support frame comprising one segment which serves as a reference and mounting frame for a plurality of optical elements disposed in a spaced relationship with respect to one another and a sensor unit associated with one of said plurality of optical elements, for determining a position and/or orientation of said movable optical elements;
- on said frame movably mounting said plurality of optical elements and fixedly mounting said sensor unit.

According to a further aspect of the present invention, there is provided a device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate using a projection optics assembly as defined in any of claims 1-9.
Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figures 2a depicts a projection optics assembly according to an embodiment of the invention;
- Figure 2b depicts a projection optics assembly according to a further embodiment of the invention;
- Figure 3 depicts a cross section of the projection optics assembly depicted in Figure 2a or 2b through line I-I;
- Figure 4 depicts a detail of the support frame of a projection optics assembly; and
- Figure 5 depicts a further detail of a projection optics assembly.

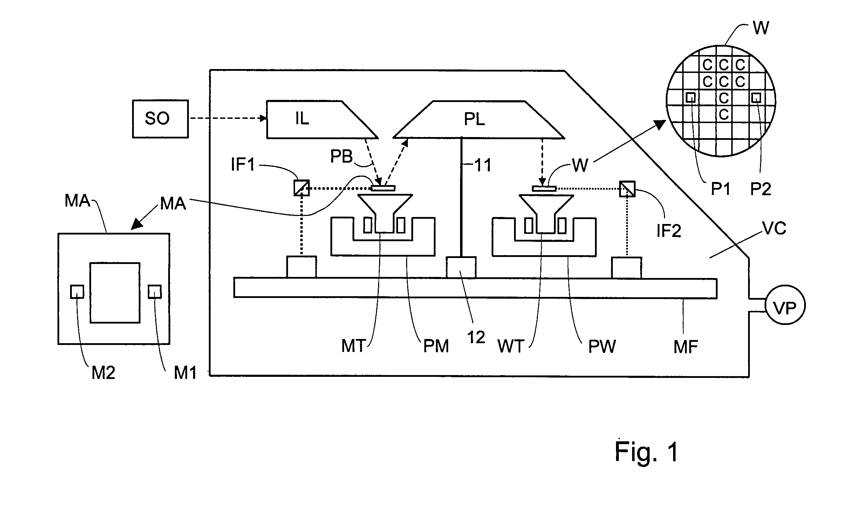

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.
   Combinations and/or variations on the above described modes of use or entirely different modes of use may also be employed.
   The lithographic apparatus of the example shown in figure 1 includes a vacuum chamber VC which is evacuated by vacuum pump VP. The beam PB impinges on mask MA and subsequently onto the target area of the substrate W in the vacuum chamber VC.
A so-called "metrology frame" MF provides an isolated frame of reference, which is mechanically isolated from the main apparatus frame. The metrology frame may be realized for example as a heavy table supported by airmounts (not shown) that provide a resilient support with a low elastic coefficient. The metrology frame MF supports sensitive components such as the interferometer IF and other position sensors and isolate them from vibration. Projection optics assembly PL is supported on metrology frame MF via a resilient element 12 and a support 11.

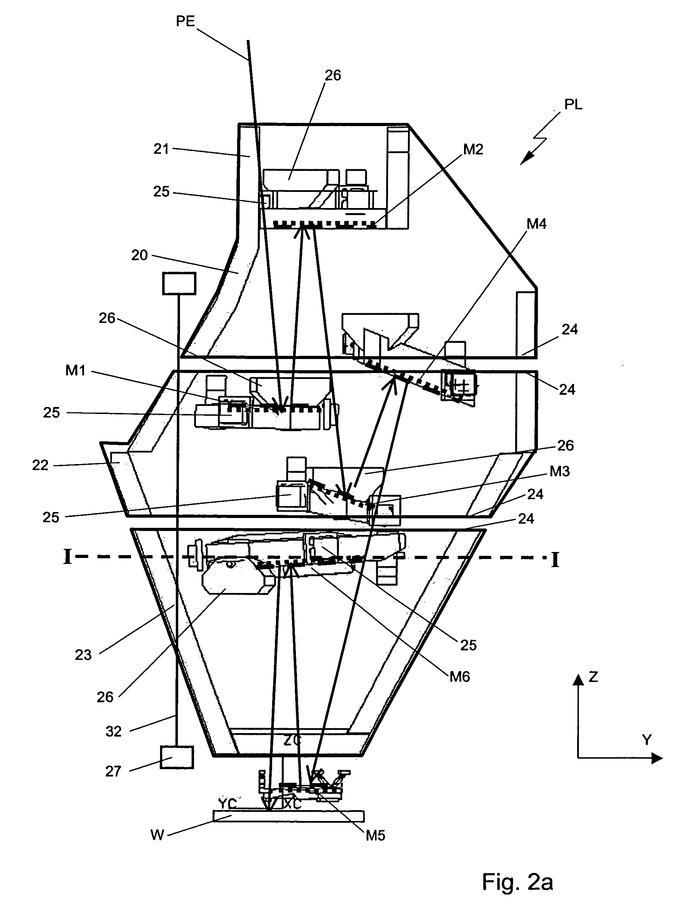

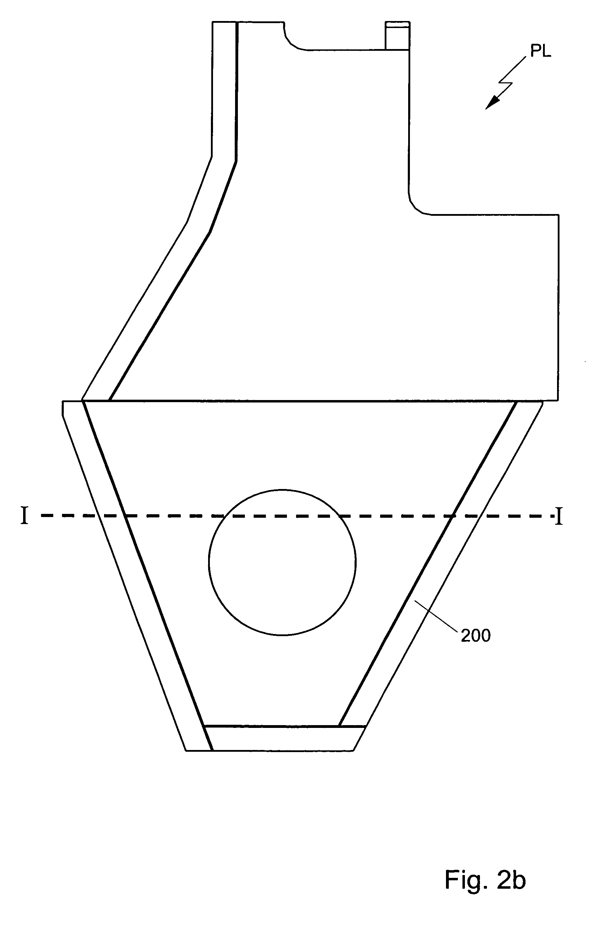

Figure 2a shows an embodiment of the projection optics assembly PL. In particular figure 2a shows a projection optics assembly PL comprising a support frame 20 comprising a plurality of segments 21, 22, 23. Figure 2b shows a further embodiment of the present invention, in particular, a projection optics assembly PL comprising a single support frame 200. This is the only difference between the two embodiments shown in figures 2a and 2b. Thus, the description below with respect to figure 2a, unless indicated otherwise, applies equally to figure 2b. Projection optics assembly PL contains a number of optical elements, preferably optical reflectors, such as optically active mirrors M1-M6 and a support frame 20. Mirrors M1-M6 are arranged to image mask MA onto substrate W. Mirrors and the support frame 21 are preferably made of a glass with low expansion coefficient such as Zerodur or ULE (ultra low expansion) glass (Zerodur and ULE are trademarks). As can be appreciated from figure 1, mirrors M1-M6 and the support frame 20 have a support on metrology frame MF. Support frame 20 is supported via a resilient element 12 to isolate the support frame 20 from vibrations of the metrology frame MF. Although only one resilient element 12 is shown in figure 1 for the sake of clarity, it will be understood that support frame 20 may be supported via a number of such elements in parallel.
In the example shown in figure 2a, the support frame comprises three segments 21, 22 and 23. Each segment contains two mirrors. Typically, mirror M6 is suspended from segment 23. All mirrors, except mirror M5 are actively positioned using Lorentz actuators. Since mirror M5 does not have to be actively positioned, it is not provided with sensors and actuators. Mirror M5 is suspended from the segment 23, where it is also fixed to the support frame 20. Construction elements (not shown) are provided to decouple mirror M5 from the surrounding support frame 20 while at the same time suspending it rigidly. As mentioned, above, in an alternative embodiment, mirror M5 is not fixed, but is mounted in the same way as mirrors M 1-M4 and M6.
In alternative embodiments any number of segments may be provided depending on the particular projection optics assembly and the designers choice. Segments may be constructed to include any number of mirrors or none at all. The total number of mirrors in the projection optics assembly will vary depending on the particular application of the projection optics assembly. For embodiments including a plurality of segments, the segments may be disposed in a stacked arrangement. In one embodiment, they may be simply stacked on top of one another to form the projection optics assembly. Other alternative embodiments are envisaged, where for example, segments may be placed side by side with one another, or a combination where, for examples, some segments of the projection optics assembly are stacked on top of one another and another segment is aligned along side. The invention is not limited in this respect, since each segment can be adapted to interconnect with its adjacent segments. In an alternative embodiment, as shown in figure 2b, the projection optics assembly PL may comprises only one "segment". In such an embodiment, although it is not necessary that that segment interconnects with other segments, if required interconnecting elements may be provided to connect that segment with others.
Each segment as shown in figure 2a, or single support frame as shown in figure 2b, combines the functionality of providing a reference frame with a mounting frame. The combined functionality means that it is not necessary that individual segments be mounted in a separate reference frame, since all segments or the single support structure 200 are referenced by virtue of the support frame 20 with respect to each other.

In a preferred embodiment, the interface area is formed by a slightly elevated area, which may be formed as a monolithic part of the frame structure. In this particular embodiment, inserts can be dispensed with. As discussed in more detail below, in alternative embodiments, where the frame structure is not formed of Zerodur, but of other alternative materials which are less brittle and stronger than Zerodur, this embodiment is preferred. When materials, such are Zerodur are used, which do have certain brittle qualities, it is advantageous to provide separate inserts.

In order to further decrease frame distortion caused by a change in interface forces, due to thermal or relaxation effects, an additional interface element may optionally be provided, to diminish these effects, although from a material properties point of view such inserts are not necessary. In the case where additional inserts may optionally be included, the design of the interface is such as to absorb the stresses, whilst keeping the stresses away from the actual support frame.

So, generally speaking, depending on material and design, an interface insert may be, by way of example only, a separate part from a different material, connected to the rest of the frame through gluing, bolting, etc., a separate part of the same material, glued, bolted, welded, etc., an integral part of the frame structure, subtly separated from its surroundings by cutting, sawing, drilling, etc. Further, such inserts may be optionally be provided, for example only, to perform the function of providing an interface of non brittle material, an interface surface capable of withstanding the surface stresses, a construction capable of withstanding and guiding the reaction forces to the clamping forces, a construction that keeps clamping induced stresses away from the support frame.

In the embodiments described above, the support frame 20, 200 is comprised of Zerodur. However, the invention is not limited in this respect. The present invention is concerned with providing one support frame, either or not segmented, instead of a separate reference frame with a number of separate mirror modules mounted in a statically determined way. As discussed the present invention provides advantages such as increased simplicity and stability, far less parts, less interfaces, relaxed tolerances, improved dynamic behaviour, improved manufacturability and improved testability. These advantages may also be attained with a support frame comprised of other ultra low expansion (ULE) materials, metal materials, such as Invar, aluminium or other ceramic materials.

The segments may be attached to each other by a clamping device 27 (see figure 2a) which comprises a rod 32, preferably a metal rod threaded at both ends, which extends through holes drilled in the support frame 20 and is attached at one or both ends to a device which exerts a force on the rod. The force, which is typically in the region of 13000 Newtons is applied constantly to the rod. In figure 2a, although for the sake of clarity only one clamping device 27 is shown, preferably, the segments are clamped at either three or four relatively large areas. If required, additional fixation elements (not shown) may be provided.
The support frame 20, 200 is constructed of Zerodur blocks, tubes, plates and other structures, as appropriate or from other materials as discussed above, in such a way to achieve sufficient stiffness. Depending on the dynamic requirements it may be necessary to provide additional elements, such as further Zerodur block components to increase the stiffness of the support frame. It will be understood that in order to reduce the effects of any vibrations or shocks on the projection optics assembly, it is necessary that the support frame 20, 200 is sufficiently stiff, both in terms of torsional as well as bending stiffness. The blocks and plate glass structures making up the support frame are connected once, with the intention that they will not be detached again from one another. However, if the need arises they may be disassembled. The support frame components are connected to each other in a stable manner, for example, by gluing. The finer details of the support frame such as the formation of interface surfaces are machined, for example, by grinding into the support frame, or by providing mounting blocks in the support frame at predetermined locations. In order to provide the clamping device 27, holes are also drilled into the support frame 20.

Each mirror M1-M6, except perhaps for mirror M5, is provided with a sensor unit 25 which detects the position of the mirror with which it is associated and an actuator 26 which in response to the sensor unit moves the mirror to a predetermined location. Typically, sensor information from all sensors is combined in order to control all actuators so to control the six degrees of freedom of the mirror. Thus, one sensor is not generally uniquely associated with one actuator. Since it is necessary to be able to move the mirrors with six degrees of freedom, the sensor units and actuators are the same type as those used in conventional projection optics assemblies. For example, for each mirror M1-M6, except perhaps for mirror M5, which may be held stationary, Lorenz actuator units including the reaction mass and the magnetic gravity compensator are provided. In particular, three actuator units 26 are provided, each containing two actuators at right angles relative to each other. At one end these units are attached to the mirror itself, and at the other end, and in contrast to conventional projection optics assemblies, each actuator unit is mounted directly in the support frame on an interface surface. Similarly, for each mirror, there are provided three sensor units 25 having an extremely high accuracy. Each sensor unit 25 is capable of measuring two dimensions. Thus, in order to measure all six degrees of freedom, three sensor units 25 are provided. The sensor units 25 are received directly on interface surfaces provided in the support frame 20. Each sensor unit 25 is disposed with respect to a reference surface 24, with relation to which the positioning of one mirror with respect to a second mirror is achieved. In a particular embodiment, the reference surface 24 is located in or on the support frame. In particular, the segments are adapted so as to interface with one another at an interface zone 34, wherein the reference surface comprises at least a part of said interface zone 34, and wherein at least one of the segments is provided with the interface surface 24 for receiving a sensor unit 25 and is adapted to accommodate the corresponding mirror.

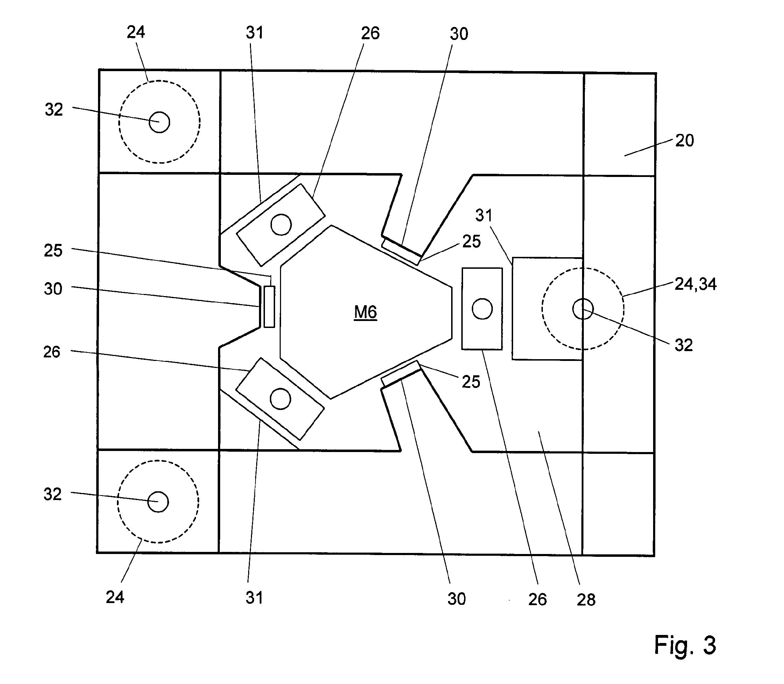

Figure 3 depicts a cross section of the projection optics assembly depicted in figure 1 through line I-I. In the example, shown in figure 3, the interface zone is shown vertically. The present invention is not limited in this respect, since the angle of the interface zone is not essential to the present invention. Indeed it may be horizontal or at any other angle. In the example, the mirror M6 is hexagonal. The sensor units 25 and actuators 26 are disposed on alternate sides of the mirror M6. The support frame 20 is provided with interface surfaces 30, 31 for receiving the sensor units 25 and actuators 26, respectively. As mentioned each sensor unit 25 includes two sensor elements. If necessary, the sensor unit 25 may also include spacers having known dimensions, wherein the spacers are arranged to dispose the sensor elements at a predetermined location. The interface surfaces 30, 31 are formed on or in the support frame 20. In the example, shown blocks of support frame material are arranged to extend into a support frame cavity 28. Also shown are rods 32 extending into the plane of the figure through the support frame 20, and shown out of the plane of figure 3 is the reference surface 24, notionally represented as a circle. It will be understood that the dimensions of the reference surface are not limited and will depend on each application. For example, the reference surface may be constructed of tubes or hollow beams. They may have a square cross section, but are not limited in terms of the construction or the shape.

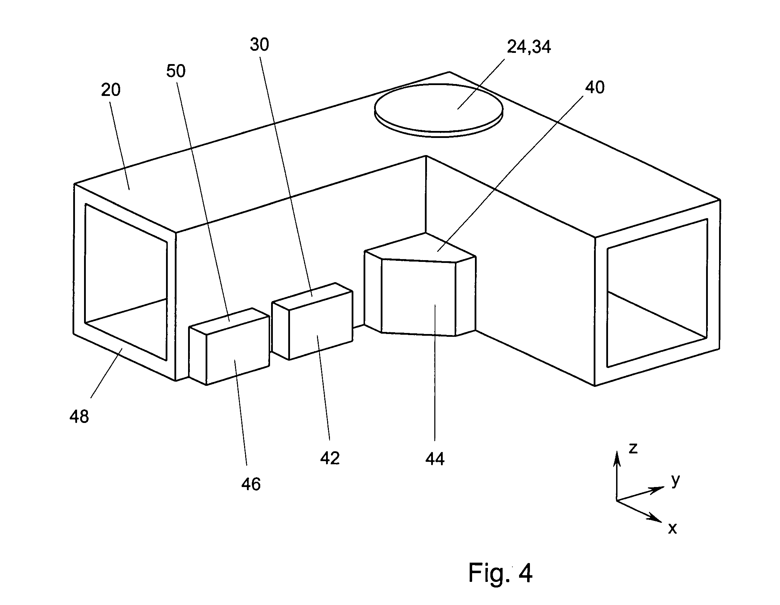

Figure 4 depicts a detail of the support frame of a projection optics assembly. The support frame 20 includes a frame constructed from tubes, such as hollow beams 48 having a square cross section. Again, the reference surface 24 is notionally shown by circle 24. Provided on the beam 20 are blocks 42, 44 and 46 the upper facing surfaces of which serve as the interface surface 30, 40, 50 for a sensor unit, an actuator and a mirror, respectively. It will be understood that the shape of the block is not critical and will depend on the particular geometry of each projection optics assembly. The blocks 42, 44, 46 are schematic representations of elements with which the sensor, actuator and mirrors interface. The actual interface may be horizontal, vertical or any other angle or orientation. Also, it is not essential that the upper surfaces provide the interface surfaces. In further embodiments, not shown, the interface surfaces may be formed in recesses formed in the support frame 20, or a combination of recesses and protruding structures. In particular, the support frame segment may be any shape or any form. It is not necessary that it is composed of tubes, having any particular cross-section. Parts may be formed from solid material, parts may be I-, T-, or U-shaped beams. The invention is not limited with respect to the form of particular parts, provided the support frame is stiff enough, provides access, and provides surfaces for all parts, interfaces and measurements required. In a particular embodiment, for example, it may be formed of solid material into which recesses are created to allow for the mirrors, sensors, actuators, cables and any other unit that may be required. Further, the blocks 46 are not essential. The functionality provided by block 46 is to provide a support for the mirror. In particular, block 46 provides a soft support for the mirror, a so-called gravity compensator. This is a unit with stiffness that is as low as possible, but which is capable of carrying the weight of the mirror. A gravity compensator may be provided in one of two embodiments. In a first embodiment, a separate gravity compensator is provided by block 46 , which may comprise, amongst other things, a spring, a magnetic assembly, or a pneumatic assembly. In this embodiment block 46 is required. In this embodiment, the gravity compensator may be provided between the mirror and the support frame 20. Alternatively, an internal gravity compensator is provided, whereby each actuator is equipped with its own gravity compensator, for example, a spring, additional magnets or a pneumatic assembly, or by providing a particular predetermined current through its coil. In this alternative embodiment, block 46 is not required.

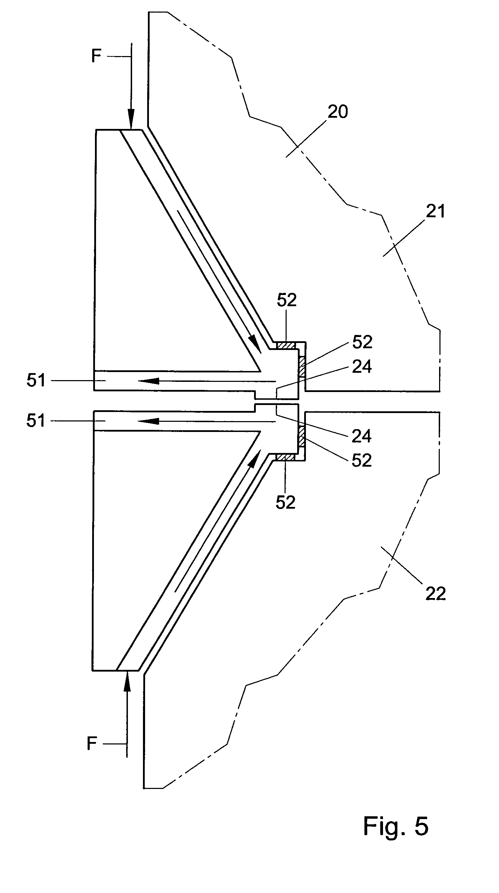

Figure 5 depicts a further detail of a projection optics assembly. In particular, a cross section through an interface between two segments. An insert 51 preferably made of a low expansion coefficient material such as Invar (Invar is a trademark) is provided. The inserts 51 are provided between adjacent segments 21, 22. The expansion coefficient of Invar, although low, is not as low as materials such as Zerodur, which is one material for the support frame. Therefore, it is desirable that the dimensions of the inserts 51 be kept as small as possible in order to minimize any possible error introduced into the system due to the thermal expansion of Invar over time. With respect to thermal stability, a typical scan for a lithographic apparatus takes approximately five minutes. Thus, it is desirable that the dynamic and thermal stability of the projection optics assembly PL is maintained for a period in the order of five minutes. To join two segments 21, 22, two inserts 51 are provided. One insert 51 interfaces with the first segment 21 and the second insert 51 with the second segment 22. In the assembled arrangement the inserts 51 are adapted to be disposed between segments to form, in use, an interface zone, so that in an assembled state the inserts 51 come into contact with one another, wherein at least a part of a surface defined by the contacting inserts forms the reference surface. The inserts 51 may be glued with glue 52 to form an integrated frame. The shape and form of the inserts will depend on the particular shape and form of the segments in a region of the interface between the two segments. In the example shown, the inserts are a hollow cone shaped element, wherein the wider base of the cone is enclosed except and the apex of the cone is also provided with a hole, to allow for the threaded metal rod 32 (see figure 2a) to provide the clamping force. The cone has a triangular vertical crossectional form, in order to obtain as much surface area contact between the inserts 51 and the support frame 20. The number of inserts, that is the number of interface planes, in a segment may be for example, three or four. Three inserts are provided in a triangular arrangement, when viewed from above, and as depicted in figure 3. Four inserts are provided in a rectangular arrangement, when viewed from above. The inserts 51 are further adapted so that when a force F, for example the clamping force is exerted on the insert, that force F is transferred through the insert, rather than being transferred into the support frame 20. This provides the advantage that the support frame material is not subject to any undue stresses which may affect the long term stability of the frame, for example, caused by creep, relation or crack forming. In a worst case, it may even cause a break down of the frame. The properties of Invar, which is one of the preferred materials for the inserts, are such that it withstands stress more optimally than Zerodur or other glass materials.

Whilst specific embodiments of the invention have been described above, it will be appreciated that the invention may be practiced otherwise than as described. The description is not intended to limit the invention.

## Claims

1. A lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection optics assembly for projecting the patterned beam onto a target portion of the substrate, said assembly comprising a plurality of movable optical elements and a plurality of sensor units for sensing the position and/or orientation of a respective optical element, said movable optical elements being arranged in a spaced relationship on a support frame, **characterized in that** said support frame comprises an assembly of at least two interconnected segments, each of said segments movably mounting at least one of said optical elements and fixedly mounting at least one of said sensor units, wherein said at least two interconnected segments serve as a reference and mounting frame within which said optical elements are mounted in said spaced relationship.

2. A lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection optics assembly for projecting the patterned beam onto a target portion of the substrate comprising a plurality of movable optical elements and a plurality of sensor units for sensing the position and/or orientation of a respective optical element, said movable optical elements being arranged in a spaced relationship on a support frame, **characterized in that** said optical elements are movably mounted and said sensor units are fixedly mounted on a single support frame, wherein said support frame comprises one segment which serves as a reference and mounting frame within which said optical elements are mounted in said spaced relationship.

3. A lithographic apparatus according to any preceding claim, wherein said sensor unit or sensor units is/are mounted directly in or on said segment or segments at a predetermined location.

4. A lithographic apparatus according to claim 1 or claim 3 when dependent on claim 1, wherein said plurality of segments are adapted to interconnect with one another in a stacked arrangement.

5. A lithographic apparatus according to any or preceding claims 1, 3 or 4, wherein said support frame comprises three segments, wherein two of said plurality of optical elements are mounted in at least each of two of said segments.

6. A lithographic apparatus according to any of preceding claims 3-5, wherein said sensor unit senses the position and/or orientation of said respective optical element with respect to a reference surface located on or in said segment or segments, and wherein said segment or segments is/are provided with an interface surface formed in said segment or segments for receiving said sensor unit, wherein said interface surface is disposed at said predetermined location, which is predetermined with respect to said reference surface.

7. A lithographic apparatus according to any of preceding claims 1 or 3-6, wherein said support frame comprises a plurality of inserts, wherein said inserts are adapted to be disposed between said segments to form, in use, an interface zone, so that in an assembled state said inserts come into contact with one another, wherein at least a part of a surface defined by said contacting inserts forms a reference surface.

8. A lithographic apparatus according to any preceding claim, wherein said segment or segments fixedly support/s an actuator coupled to said respective one of said plurality of optical elements, said actuator being responsive to a sensor unit, for moving said optical element to a predetermined location.

9. A lithography apparatus according to any of preceding claims 1 or 3-8, wherein when assembled, the segments interface with each other in a substantially horizontal plane.

10. A method of assembling a projection optics assembly for a lithographic apparatus comprising the steps of:
- providing a plurality of interconnectable segments;
- on each segment movably mounting a plurality of optical elements disposed in a spaced relationship with respect to one another, and fixedly mounting at least one sensing element so as to sense the position and/or orientation of one of said plurality of said movably mounted optical elements; and
- interconnecting said segments so as to at least partially form a single segmentable support frame which serves as a reference and mounting frame within which said optical elements are mounted in said spaced relationship.

11. A method of assembling a projection optics assembly for a lithographic apparatus comprising the steps of:
- providing a single support frame comprising one segment which serves as a reference and mounting frame for a plurality of optical elements disposed in a spaced relationship with respect to one another and a sensor unit associated with one of said plurality of optical elements, for determining a position and/or orientation of said movable optical elements;
- movably mounting said plurality of optical elements and fixedly mounting said sensor unit on said frame.

12. A device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate using a projection optics assembly as defined in any of preceding claims 1-9.
